Europäisches Patentamt

European Patent Office

Office européen des brevets

(19)

(11) Numéro de publication : **0 598 647 A1**

(12) **DEMANDE DE BREVET EUROPEEN**

(21) Numéro de dépôt : **93402748.3**

(22) Date de dépôt : **09.11.93**

(51) Int. Cl.⁵ : **G01R 29/08,** G01R 15/07

(30) Priorité : **19.11.92 FR 9213899**

(43) Date de publication de la demande :
**25.05.94 Bulletin 94/21**

(84) Etats contractants désignés :
**CH DE DK ES FR GB IT LI NL SE**

(71) Demandeur : **THOMSON-CSF**
**173, Boulevard Haussmann**
**F-75008 Paris (FR)**

(72) Inventeur : **Eumurian Grégoire**
**Thomson-CSF,**
**SCPI,**
**B.P. 329**
**F-92402 Courbeboie Cédex (FR)**

(74) Mandataire : **Benoit, Monique et al**
**THOMSON-CSF**
**SCPI**
**B.P. 329**
**50, rue Jean-Pierre Timbaud**
**F-92402 Courbevoie Cédex (FR)**

(54) **Capteurs électromagnétiques semi-actifs à fonction de transfert distribuée.**

(57) Dispositif de traitement d'un signal électrique provenant d'un capteur (10) du type dérivatif destiné à mesurer un champ électrique ou magnétique, des courants de charge de surface ou autres grandeurs dérivés, le signal électrique ayant un spectre de fréquence comprenant une bande de fréquences supérieures à une fréquence basse $f_1$, le dispositif comportant

— des moyens (20) électroniques d'intégration d'une partie de ce signal comprenant une partie du spectre de fréquence située au-dessus d'une haute fréquence prédéterminée $f_2$ supérieure à $f_1$ ;

— des moyens (21) de compensation amplifiant et intégrant une partie du signal composée des parties de son spectre de fréquence comprise entre les fréquences $f_1$ et $f_2$, ces moyens de compensation ayant un gain qui est une fonction décroissante de la fréquence dans la bande de fréquence entre $f_1$ et $f_2$ et constante en fonction de la fréquence au dessus de $f_2$, le dispositif étant caractérisé en ce qu'il comporte en aval des moyens (20) d'intégration un canal optique (30) recevant les signaux électriques en provenance des moyens d'intégration (20) les transformant en signaux optiques et les transmettant à distance sous cette forme, et les restituant sous forme électrique, les moyens (21) de compensation étant situés fonctionnellement en aval du canal optique (30).

Application : Mesure de perturbation telle que foudre ou I.E.M.

FIG.3

EP 0 598 647 A1

Jouve, 18, rue Saint-Denis, 75001 PARIS

EP 0 598 647 A1

Le domaine de l'invention est celui des dispositifs de mesure de signaux dans le domaine des phénomènes large bande.

Plus précisément, la présente invention concerne un dispositif de traitement de signaux provenant notamment de capteurs d'impulsions électromagnétiques nucléaires (IEM), de foudre ou de compatibilité électromagnétique (CEM). De tels capteurs peuvent consister en des capteurs large bande de champs électriques, magnétiques, de courants ou de charges de surface, présentant une réponse en fréquence s'étendant depuis 10 à 100 KHz environ jusqu'à plus de 10 GHz. L'invention est destinée en particulier mais non exclusivement à la mesure des champs parasites engendrés par de tels phénomènes (foudre IEM...) à l'intérieur d'enceintes électromagnétiquement protégées telles que cages de Faraday ou abris protégés.

Le brevet "Dispositif de traitement d'un signal provenant d'un capteur ayant une réponse du type dérivatif" (auteur : G. Eumurian - n° FR-90 11679 déposé le 21/09/90) décrivait le principe d'un dispositif, qui associé à un capteur dérivatif (de champ électrique, magnétique, courant ou charge de surface) permettait un gain d'environ 60 sur la sensibilité du capteur. Ce principe différent à la fois de celui des capteurs passifs (intégration du signal sur la totalité de la bande passante utile) et celui des capteurs actifs (utilisation d'éléments actifs à l'intérieur même du capteur) conduisait à garder des capteurs entièrement passifs ce qui permettait leur miniaturisation, indispensable avec l'utilisation en très haute fréquence tout en augmentant sensiblement leur sensibilité.

Le capteur passif standard était suivi non pas d'un intégrateur et d'un amplificateur, mais d'un ensemble d'intégration et compensation.

Les capteurs dérivatifs de type classique sont pour les grandeurs électromagnétiques constitués par des circuits RC. Ces capteurs ont une courbe de réponse (niveau de sortie/fréquence) que l'on peut considérer comme plate à partir d'une fréquence dite de coupure $F_2$ égale à $\dfrac{1}{2\pi R_2 C_2}$ (1) et une courbe dre réponse ayant une pente d'environ 6 dB par octave avant cette fréquence de coupure.

La compensation permettait d'étendre la bande passante vers les fréquences basses. Cette compensation est réalisée entre $f_1$ et $f_2$ $f_1 < f_2$.

C'est pourquoi dans ce brevet il était prévu un capteur passif standard 10 relié à une résistance de charge 12, par l'intermédiaire d'un câble d'impédance, égale à celle de la résistance de charge. Ce capteur passif a une courbe de réponse, comme expliqué plus haut, qui est plate au dessus de la fréquence de coupure $f_2$ et une pente d'environ 6 dB par octave avant cette fréquence de coupure en particulier entre une fréquence $f_1$ inférieure à $f_1$, et $f_2$.

Afin de rétablir la platitude de la réponse au même niveau que le niveau atteint à partir de $f_2$ il était prévu selon ce brevet un circuit électronique de compensation qui amplifie le signal reçu, de façon linéairement décroissante avec les fréquences, entre $f_1$ et $f_2$ et de façon constante au-delà de $f_2$, selon une courbe de gain représentée en figure 3 de ce brevet. Cet arrangement permet comme expliqué, page 6 ligne 25 - page 7 ligne 26 de ce brevet, d'améliorer la sensibilité en faisant diminuer le niveau du bruit associé au signal.

L'ensemble intégration et compensation présentait une bande passante commençant à $f_1$.

A titre d'exemple, on peut indiquer que pour un capteur de champ électrique de surface équivalente A = $10^{-2}$ m² et Rc = 50Ω en intégrant entre $f_2$ = 10 MHz et 1 GHz et en compensant entre $f_1$ = 100 KHz et $f_2$ = 10 MHz on obtenait une diminution du bruit d'environ 36 dB.

Le but de la présente invention est d'une part d'améliorer encore la sensibilité et d'autre part et surtout d'améliorer vers les hautes fréquences la largeur de bande du signal tout en gardant l'avantage d'avoir une fréquence de coupure basse plus basse. Alors qu'avec un capteur du type de celui décrit dans le brevet FR-90 11679 déjà cité la fréquence de coupure haute se situe à quelques GHz on peut envisager grâce à la présente invention des fréquences de coupure haute de l'ordre de quelques dizaines de GHz.

Il est connu que la limitation vers les fréquences hautes est due à la présence à proximité du capteur, constitué par exemple d'une antenne selfique ou capacitive, des circuits de traitement du signal capté. Ces circuits constituent des masses métalliques toujours à l'origine de perturbations des signaux que l'on veut capter. Pour diminuer le volume des masses métalliques il est connu de ne laisser à proximité du capteur que des circuits électroniques de conditionnement. Ces circuits transforment le signal électrique capté en signal optique, et peut donc être transmis sur de relativement grandes distances sans affaiblissement notoire par exemple au moyen d'une fibre optique. Le gain vers les fréquences hautes provient de ce que les circuits de conditionnement sont moins volumineux et moins consommateurs d'énergie, ce qui entraîne une diminution du volume de batterie, que les circuits électroniques de traitement du signal. Ces derniers reçoivent le signal sous forme optique à une distance du capteur suffisante pour ne pas perturber la mesure.

L'idée à la base de l'invention est donc pour diminuer encore le volume des masses métalliques à proximité du capteur, de ne conserver que l'un des deux éléments du capteur à proximité immédiate du capteur, à savoir les moyens d'intégration. Le conditionneur met les signaux en sortie de l'intégrateur sous forme optique.

2

Le circuit compensateur, peut dans ces conditions être déporté à une distance suffisante du capteur pour ne plus le perturber. Cela suppose évidemment de faire précéder le compensateur déporté, d'un récepteur optique transformant les signaux optiques en signaux électriques. Dans la suite de l'exposé, le convertisseur électrique optique sera appelé émetteur optique et le convertisseur optique électrique récepteur optique.

Ces objectifs ainsi que d'autres qui apparaîtront par la suite sont atteints grâce à un dispositif de traitement d'un signal électrique provenant d'un capteur du type dérivatif destiné à mesurer un champ électrique ou magnétique, des courants de charge de surface ou autres grandeurs dérivées, le signal électrique ayant un spectre de fréquence comprenant une bande de fréquences supérieures à une fréquence basse $f_1$, le dispositif comportant

- des moyens électroniques d'intégration d'une partie de ce signal comprenant une partie du spectre de fréquence située au dessus d'une haute fréquence prédéterminée $f_2$ supérieure à $f_1$.
-

des moyens de compensation amplifiant et intégrant une partie du signal composée des parties de son spectre de fréquence comprise entre les fréquences $f_1$ et $f_2$, ces moyens de compensation ayant un gain qui est une fonction décroissante de la fréquence dans la bande de fréquence entre $f_1$ et $f_2$ et constante en fonction de la fréquence au dessus de $f_2$, le dispositif étant caractérisé en ce qu'il comporte en aval des moyens d'intégration un canal optique recevant les signaux électriques en provenance des
moyens d'intégration, les transformant en signaux optiques et les transmettant à distance sous cette forme et les restituant sous forme électrique, les moyens de compensation étant situés fonctionnellement en aval du canal optique.

Dans le mode préféré de réalisation, un circuit d'amplification placé en sortie des moyens d'intégration permet d'adapter le niveau de bruit électrique en sortie des moyens d'intégration au niveau du bruit optique dans le canal. Il sera expliqué plus loin que cette façon de faire optimise le compromis entre la sensibilité du dispositif et la valeur de son niveau signal/bruit. Dans un mode de réalisation l'émetteur optique comporte une diode électroluminescente ou laser et le récepteur une photodiode PIN ou avalanche.

De préférence, la pente du gain des moyens de compensation en fonction de la fréquence entre les fréquences $f_1$ et $f_2$ est de -6 dB par octave. On aura cependant intérêt à s'écarter de cette valeur si la pente des moyens d'intégration entre $f_1$ et $f_2$ n'avait pas une valeur de 6 dB par octave. Il conviendrait dans ce cas d'avoir pour la pente des moyens de compensation une pente de valeur égale et de signe opposé à la pente des moyens d'intégration entre $f_1$ et $f_2$.

Les moyens d'intégration qui comprennent un circuit $R_2C_2$ se situent en amont du conditionneur. Ce circuit intègre, comme dans l'art antérieur, les signaux à partir d'une fréquence $f_2 = \dfrac{1}{2\pi R_2 C_2}$.

Le circuit de compensation qui étend la réponse globale du capteur jusqu'à une fréquence $f_1 < f_2$ se trouve lui en aval du récepteur optique et donc éloigné du capteur. De ce fait, on diminue le volume métallique à proximité du capteur non seulement en raison de la différence de volume entre les circuits de compensation et le circuit convertisseur, mais aussi du fait de la différence de consommation électrique qui permet de diminuer le volume de batterie situé à proximité du capteur.

Du fait que le circuit compensateur se trouve éloigné du capteur, on n'est plus soumis à des contraintes de volume et de consommation relativement à ce circuit. Il est donc toujours possible de conserver un circuit compensateur sous forme analogique, mais dans la forme préférée de réalisation les circuits situés en aval du récepteur optique comportent des circuits de conversion analogique/numérique permettant de réaliser un traitement numérique du signal. Dans ce cas la fonction de compensation est réalisée entre $f_1$ et $f_2$ (par exemple entre 100 KHz et 10 MHz) par logiciel. Toute méthode de filtrage numérique est acceptable. A titre d'exemple, on peut citer la méthode suivante :

a) transformée de Fourier rapide (FFT) du signal pour passer du domaine temporel au domaine fréquenciel.

b) multiplication de la fonction obtenue par la fonction de transfert du filtre de compensation soit :

$$T(s) = k\frac{s + 2\pi f_2}{s + 2\pi f_1}$$

formule dans laquelle T(s) est la fonction de transfert et s le symbole des transformées de Laplace.

- Transformée de Fourier inverse pour retrouver dans le domaine temporel le signal ainsi multiplié.

D'autres caractéristiques et avantages de la présente invention apparaîtront à la lecture de la description suivante d'un mode de réalisation préférentiel de la présente invention donné à titre explicatif et non limitatif et des dessins annexés dans lesquels :

- la figure 1 représente un capteur selon l'art antérieur tel qu'il ressort de la demande de brevet FR-90 11679 du même inventeur ;

- la figure 2 représente la courbe du gain des moyens de compensation en fonction du logarithme de la fréquence ;
- la figure 3 est un schéma de principe d'un capteur selon la présente invention ;
- la figure 4 représente le canal optique de transmission ;
- la figure 5 représente un mode de réalisation possible de l'émetteur et du récepteur optique ;
- les figures 6 et 7 représentent des exemples analogiques de réalisation de circuit de compensation ;
- la figure 8 représente un dispositif numérique de réalisation des moyens de compensation.

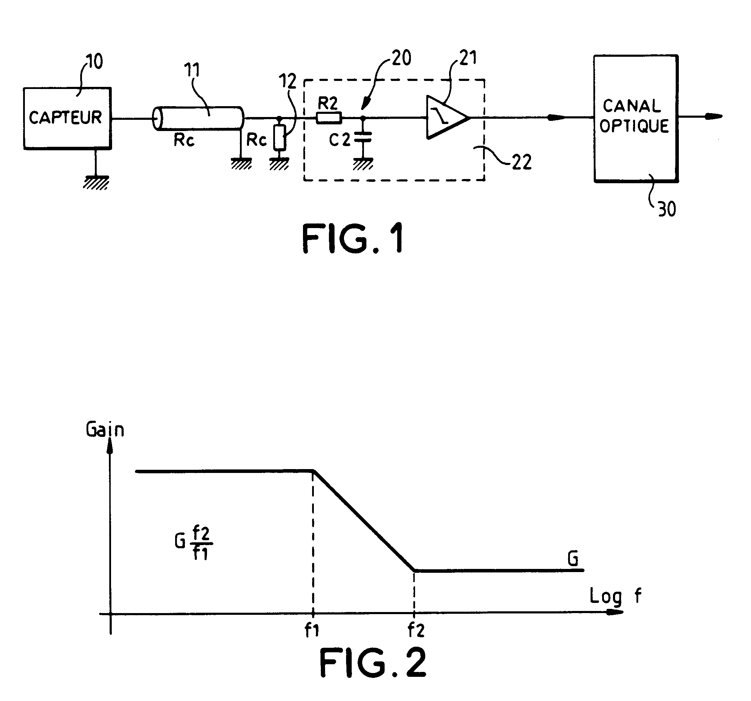

La figure 1 représente un capteur selon l'art antérieur tel qu'il ressort de la figure 2 de la demande de brevet FR-90 11679 et décrit page 5 lignes 26 à 31 de cette demande.

Un capteur passif standard 10 est relié à une résistance de charge 12 de valeur $R_c$ à travers un câble 11 d'impédance Rc.

Le traitement du signal reçu est assuré par un dispositif 22 comprenant des moyens d'intégration 20 et des moyens de compensation 21.

Les moyens d'intégration 20 pouvant notamment consister en une cellule $R_2C_2$ du type passe-bas. On a ainsi :

$$f_2 = 1 \Big/ \left( 2\pi R_2 C_2 \right) > f_1$$

L'intégration à partir de la fréquence $f_2$ supérieure à la fréquence $f_1$ conduit à une sensibilité du dispositif $f_2/f_1$ fois plus importante. La fréquence de coupure basse est cependant passée de $f_1$ à $f_2$ et les signaux provenant du capteur dérivatif 10 ne peuvent plus être intégrés à partir de la fréquence $f_1$.

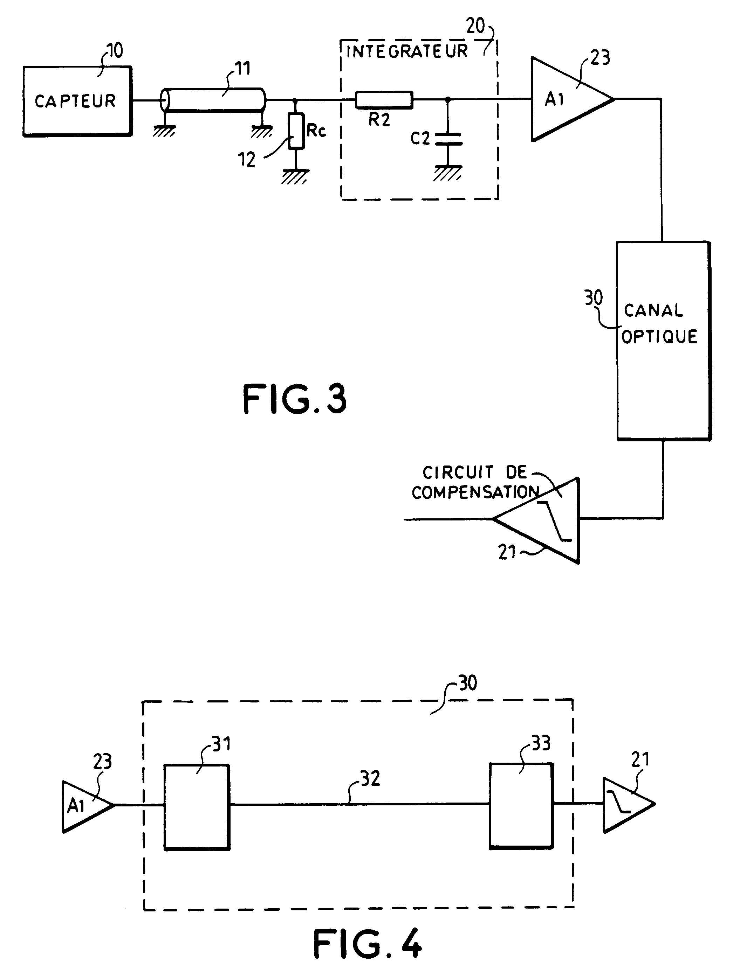

C'est pourquoi, les moyens d'intégration 20 sont suivis par un amplificateur 21, constituant des moyens de compensation, ayant une réponse particulière, pour compenser la perte de la réponse aux fréquences basses. La courbe de réponse de cet amplificateur 21 est représentée à la figure 3 de la demande de brevet et décrite page 6 lignes 3 à 10. Elle est rappelée ci-après en référence à la figure 2.

L'amplificateur 21 présentes :
- une réponse plate de gain $G.f_2/f_1$ de 0 à $f_1$
- une pente de -6 dB/octave de $f_1$ à $f_2$
- une réponse plate de gain G à partir de $f_2$

Ce système d'intégration avec une constante de temps $\Gamma_2$ faible suivie d'une compensation des fréquences basses permet un gain considérable en sensibilité sans sacrifier la réponse aux fréquences basses.

La sortie de l'amplificateur 21 est suivie d'un canal optique de transmission 30 permettant de transmettre le signal sous forme optique à une station de traitement déportée non représentée figure 1.

Le dispositif selon l'invention est représenté figure 3. Sur cette figure les éléments ayant même fonction que ceux représentés figure 1 portent les mêmes références.

Un capteur passif standard 10 est relié à un circuit d'intégration 20 comportant une résistance $R_2$ et une capacité $C_2$ à travers un câble 11 d'impédance Rc. Un amplificateur 23 de gain $A_1$ amplifie le signal en sortie du circuit d'intégration 20. Le signal en sortie du circuit d'intégration 20 est transmis à travers un canal optique 30 à un circuit de compensation 21. Le circuit 21 a une courbe de gain identique à celle représentée figure 2, la valeur $A_1$ remplaçant la valeur G.

Le canal optique 30 est représenté figure 4. Il comporte un émetteur optique 31, un moyen de transmission 32, en général une ou plusieurs fibres optiques, et un récepteur optique 33.

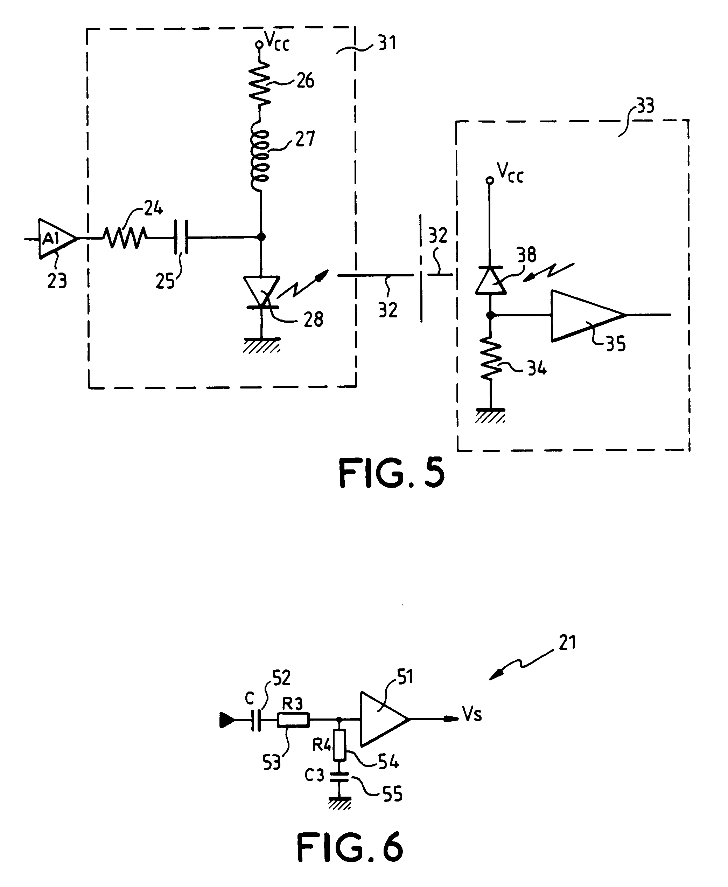

Un exemple de réalisation des circuits 31 et 33 est représenté figure 5. Pour le circuit 31 une diode électroluminescente ou laser 28 polarisée à travers une résistance de charge 26 et une inductance de choc 27 reçoit le signal en sortie de l'amplificateur $A_1$ 23 à travers une résistance 24 et une capacité 25. La lumière émise par la diode 28 est envoyée à travers la fibre 32 vers le récepteur optique 33. Ce dernier comporte une photodiode 38 PIN ou avalanche (APD) polarisée à travers une résistance 34. Un amplificateur 35 remet à niveau le signal électrique en sortie de la photodiode 38.

Des comparaisons de sensibilité et de rapport signal sur bruit entre l'art antérieur et selon la présente invention seront maintenant effectuées.

Les bruits dans la chaîne de transmission selon l'art antérieur représenté figure 1 ont deux provenances :
- les bruits thermodynamiques produits au niveau de l'amplificateur 21 de gain G dans l'art antérieur, 23 de gain $A_1$ selon la présente invention placé en aval du capteur et les bruits au niveau de la résistance $R_2$ d'intégration,
- les bruits de la liaison optique elle-même.

Des performances optimales sont obtenues si le gain de l'amplificateur G ou $A_1$ est réglé pour placer ces

4

deux bruits au même niveau. En effet, si le bruit thermodynamique est dominant, la sensibilité est légèrement meilleure mais le rapport signal/bruit est dégradé (on est dans ce cas si l'amplification $A_1$ est très forte; le bruit de la liaison optique n'intervient plus mais la liaison optique ayant une valeur maximale admissible à l'entrée le signal/bruit se réduit). Si le bruit thermodynamique est plus faible que le bruit de la liaison optique le rapport signal/bruit augmente légèrement mais la sensibilité diminue, le bruit dominant étant celui de la liaison optique.

Ce point sera explicité plus en détail ci-après en examinant trois cas a, b, c.

Dans le cas a) $GB_1 \gg B_2$, dans le cas b) $GB_1 \ll B_2$ et enfin dans le cas c) $GB_1 = B_2$.

Il sera admis pour les calculs qui vont suivre que le canal de transmission optique incluant les émetteur et récepteur optiques ainsi que la fibre de liaison présente un bruit $B_2$ et ne peut accepter que des signaux de valeur maximum $\mp V_2$. Si l'on admet que les signaux sont effectivement à ce niveau, le rapport S/B de ce canal est $S/B = V_2/B_2$.

Le bruit à l'entrée de l'amplificateur 21 alimentant le canal 30 est de $B_1$ et devient $GB_1$ à la sortie de l'amplificateur 21 de gain égal à G.

a) si l'on admet que $GB_1 \gg B_2$ le bruit total à l'entrée du canal optique est :

$$\left( B_{tot} \right)_{canal} = \sqrt{B_2{}^2 + \left( G\,B_1 \right)^2} \quad \approx GB_1$$

Le bruit total à l'entrée de la chaîne de mesure est de :

$$\left( B_{Total} \right)_E = \frac{GB_1}{G} = B_1$$

Le signal maximum ramené à l'entrée est quant à lui :

$$\left( V_{MX} \right)_E = \frac{V_2}{G}$$

et le signal sur bruit à l'entrée est de :

$$\left( \frac{S}{B} \right)_E = \frac{V_2}{GB_1}$$

b) si l'on se place maintenant dans l'hypothèse où $GB_1 \ll B_2$ le bruit total du canal optique est :

$$\left( B_{tot} \right)_{canal} = \sqrt{B_2{}^2 + \left( G\,B_1 \right)^2} \quad \approx B_2$$

Le bruit total ramené à l'entrée de la chaîne de mesure est :

$$\left( B_{Total} \right)_E = \frac{B_2}{G}$$

et comme $\frac{B_2}{G} \gg B_1$, il en résulte que le bruit ramené à l'entrée a fortement augmenté. Le rapport sianal sur bruit, S/B, à l'entrée devient :

$$\left( \frac{S}{B} \right)_E = \frac{V_2/G}{B_2/G} = \frac{V_2}{B_2}$$

c) si l'on se place enfin dans l'hypothèse où $GB_1 = B_2$, le bruit total du canal optique devient :

$$\left(B_{tot}\right)_{canal} = \sqrt{2B_1{}^2G^2} = \sqrt{2}\,GB_1$$

Le bruit total ramené à l'entrée de la chaîne de mesure est :

$$\left(B_{Total}\right)_E = \frac{\sqrt{2}\,GB_1}{G} = \sqrt{2}\,B_1 = 1,41\;B_1$$

Le signal maximum ramené à l'entrée est inchangé soit $V_2/A_1$ et le rapport signal/bruit à l'entrée est :

$$\left(\frac{S}{B}\right)_E = \frac{V_2/G}{\sqrt{2}\,B_1} = 0,7\frac{V_2}{GB_1}$$

En résumé, pour les trois cas, on peut dresser le tableau suivant :

| cas | | a<br>$GB_1 > > B_2$ | b<br>$GB_1 < < B_2$ | c<br>$GB_1 = B_2$ |
|---|---|---|---|---|
| S/B | | $V_2 / G\,B_1$ | $V_2 / B_2$ | $0,7\;V_2/GB_1 = 0,7\;V_2/B_2$ |
| Bruit à l'entrée | | $B_1$ | $B_2/G > > B_1$ | $1.4\;B_1$ |
| Application numérique | G | 30 | 3 | 10 |
| $B_1 = 10^{-4}$ V eff<br>$B_2 = 10^{-3}$ V eff<br>$V_2 = 1$ V eff | S/B | $1/30.10^{-4} = 330$ | $1/10^{-3} = 1000$ | $0,7 \times 1/10^{-3} = 700$ |
| | B | $100\;\mu V$ | $10^{-3}/3 = 330\mu V$ | $140\mu V$ |

On voit sur ce tableau que dans le c), pour un rapport S/B diminué d'un facteur 0,7 par rapport au cas b) on a un seuil de sensibilité (140 µV) plus de deux fois inférieur.

Par comparaison au cas a), on voit que dans le cas c) pour un seuil de sensibilité augmenté d'un facteur 1,4, on a un rapport S/B multiplié par un facteur supérieur à 2. Le cas c) représente donc bien le meilleur compromis.

Cette parenthèse relative à l'optimisation du gain G ou $A_1$ de l'amplificateur situé en amont du canal optique 30 étant faite, nous revenons au calcul du bruit ramené à l'entrée et du rapport signal/bruit dans le cas de l'art antérieur. L'exemple numérique cité page 6 ligne 30 de la demande de brevet FR-90 11679 est ci-après repris.

On suppose que le bruit à l'entrée de l'amplificateur 21 est de 100 µV eff.

On intègre à partir de 10 MHz et on compense entre 100 KHz et 10 MHz, le but étant d'obtenir une réponse plate entre 100 KHz et 1 GHz.

On suppose un bruit propre au canal optique de 1,6 mV eff avec un signal maximum d'entrée égal à ∓1V. Le bruit dans la bande 10 MHz - 1 GHz est de 100 µV eff.

Le bruit dans la bande 100 KHz - 10 MHz est pour un filtre parfait $100\;\mu V \times \sqrt{\dfrac{100KHz}{1GHz}}$, soit :

$100\sqrt{\dfrac{10^5}{10^9}} = 1\mu$ V efficace,

et pour un filtre à -6 dB/octave : $1\mu\;V \times \sqrt{\dfrac{\pi}{2}} = 1,25\mu$ Veff

6

EP 0 598 647 A1

Ce bruit est amplifié avec un gain supplémentaire $\frac{f_2}{f_1} = \frac{10^7 Hz}{10^5 Hz} = 100$.

Il se trouve donc à l'entrée du canal avec une valeur de 1,25 μV x 100 = 125 μV efficace.

Le bruit total à l'entrée du canal est donc $\sqrt{100^2 + 125^2} = 160\mu$ Veff.

Le bruit du canal optique 30 étant de 1,6 mV eff, le bruit total à l'entrée de la chaîne de mesure est : ($B_{total}$) entrée=$\sqrt{160^2 + 160^2}$ = 224μ V.

Ce résultat est obtenu en amplifiant entre l'entrée électrique et l'entrée optique de 20 décibels de façon à avoir un bruit électrique et un bruit canal optique identiques.

Le rapport signal/bruit est dans ce cas de :

$$\frac{S}{B} = \frac{100mV}{224\mu V} = 446 \ (53dB)$$

La sensibilité d'entrée est de 224 μV efficace.

Le même calcul va maintenant être effectué pour un dispositif selon l'invention mais avec fonction de transfert distribuée comme représenté figure 3.

Dans ce type de fonctionnement la compensation n'est plus réalisée avant le canal optique. De ce fait, le bruit de la partie électrique (amplificateur 23 de gain $A_1$) étant plus faible, on est amené à augmenter le gain $A_1$ pour avoir le même niveau de bruit électrique et optique à l'entrée du canal optique 30. Le gain $A_1$ doit dans ce cas, avec les mêmes valeurs numériques que précédemment, être de 16 au lieu de 10. Le bruit électrique dans la bande 10 MHz - 1 GHz à l'entrée du canal optique est : 100 μV x 16 = 1,6 mV eff.

Le bruit total électrique et optique est à ce niveau de :

$$\sqrt{1,6mV^2 + 1,6mV^2} = 2,24mV efficace$$

Le signal dans le canal optique étant toujours de ∓1V, le canal optique transmet donc un signal avec un rapport signal/bruit de

$$\frac{S}{B} = \frac{1V}{2,24mV} = 446 \ (53 \ dB)$$

Le bruit d'entrée est de : $\frac{2,24mV}{16} = 140\mu$ Veff.

Après transmission par le canal optique le signal est compensé entre 100 KHz et 10 MHz. Cette compensation a pour effet d'ajouter un bruit supplémentaire dans cette bande. Le bruit ramené à l'entrée dans cette bande est de 140 μV. Le bruit dans cette bande pour un filtre parfait serait :

$$140x\sqrt{\frac{100KHz}{1GHz}} = 1,4\mu \ Veff$$

et pour un filtre à -6 dB/octave : $1,4\sqrt{\frac{\pi}{2}} = 1,75\mu$ V

Ce bruit est amplifié avec un gain supplémentaire de

$$100 \left( \frac{f_2}{f_1} = \frac{10MHz}{0,1MHz} \right)$$

Il se trouve donc ramené à l'entrée avec la valeur :
1,75 x 100 = 175 μV.

Le bruit total ramené à l'entrée de la chaîne de mesure est de :

$$\sqrt{140^2 + 175^2} = 224\mu \ Veff$$

Le bruit d'entrée est donc resté inchangé. La modification du gain de l'étage d'entrée de 10 à 16 entraîne une augmentation du bruit à l'entrée du canal optique de 16/10 (4 dB) et donc une diminution du rapport signal/bruit de 4 dB. La distribution de la fonction de transfert conserve donc la sensibilité d'entrée et n'entraîne qu'une légère diminution du rapport signal/bruit. Par contre la largeur de bande du signal est fortement augmentée vers les hautes fréquences du fait de la diminution du volume des circuits et de l'alimentation à proximité du capteur.

Des indications sur la façon de réaliser en analogique ou en numérique les circuits de compensation seront données brièvement ci-après. Les modes de réalisation analogiques sont déjà décrits pages 9 et 10 (figures 5 et 6) de la demande de brevet FR 90.11679.

La figure 6 représente un premier mode analogique de réalisation. Le signal en sortie de l'amplificateur 35 (figure 5) du récepteur optique 33 est introduit par l'intermédiaire d'une capacité C 52 sur un amplificateur 51 par l'intermédiaire d'un réseau $R_3$ série $R_4$ $C_3$ parallèle. Ces éléments sont référencés respectivement 53,

EP 0 598 647 A1

54, 55.

L'amplificateur 51 doit présenter une impédance d'entrée nettement plus élevée que $R_3$. La fonction de transfert du réseau $R_3\ R_4\ C_3$ est donné par la relation

$$T(s) = \frac{R_4}{R_3 + R_4} \cdot \frac{s + 2\pi f_2}{s + 2\pi f_1} \quad (1)$$

avec $R_3\ R4$ et $C_3$ choisis de telle sorte que

$$2\pi f_1 = \frac{1}{(R_3 + R_4)C_3}$$

$$2\pi f_2 = \frac{1}{R_4 C_3}$$

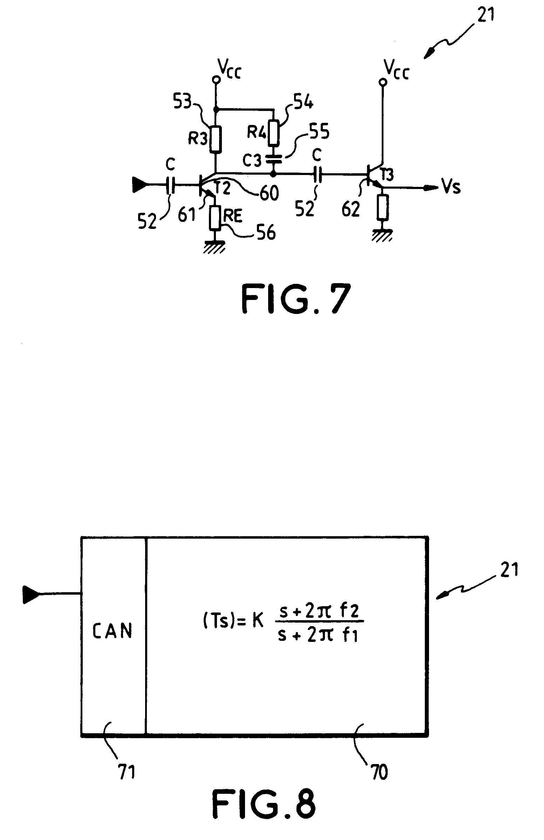

La figure 7 représente un autre mode de réalisation d'un dispositif de compensation à monter en aval du récepteur optique 33.

Le circuit de compensation est constitué par un transistor $T_2$ 60 et un réseau constitué par les résistances $R_3$ 53, $R_4$ 54 et la capacité $C_3$ 55.

Le collecteur 61 du transistor $T_2$ 60 est relié à la masse par l'intermédiaire d'une résistance $R_e$ 56. Le gain, Av du transistor $T_2$ est donné par la relation

$$Av = \frac{R_3 R_4}{R_3 + R_4} \times 1 / Re\ \frac{s + \frac{1}{R_4 C_3}}{s + \frac{1}{C_3\left(R_3 + R_4\right)}}$$

avec comme précédemment

$$2\pi f_1 = \frac{1}{(R_3 + R_4)C_3}$$

$$2\pi f_2 = \frac{1}{R_4 C_3}$$

Un transistor $T_3$ 63 en aval du transistor $T_2$ 60 est monté en collecteur commun et permet une adaptation d'impédance.

Dans les schémas des figures 6 et 7 les condensateurs C 52 permettent de limiter la bande en dessous de $f_1$ et de diminuer ainsi encore le bruit.

Les figures 6 et 7 ne sont destinés qu'à illustrer des modes possibles de réalisation des circuits de compensation en mode analogique. Tout autre mode ayant la même fonction de transfert peut convenir. En particulier et comme il a été indiqué plus haut, selon le mode préférentiel de réalisation de l'invention la compensation est réalisée en numérique. Dans ce cas comme représenté figure 8 le signal en sortie du récepteur optique 33 est introduit dans un calculateur 70 par l'intermédiaire d'une carte d'adaptation et de conversion analogique numérique 71. Le calculateur calcule alors directement sur les échantillons numériques la fonction de transfert de compensation soit

$$T(s) = K\frac{s + 2\pi f_2}{s + 2\pi f_1}$$

**Revendications**

1. Dispositif de traitement d'un signal électrique provenant d'un capteur (10) du type dérivatif destiné à mesurer un champ électrique ou magnétique, des courants de charge de surface ou autres grandeurs dérivés, le signal électrique ayant un spectre de fréquence comprenant une bande de fréquences supérieures à une fréquence basse $f_1$, le dispositif comportant
   - des moyens (20) électroniques d'intégration d'une partie de ce signal comprenant une partie du spectre de fréquence située au-dessus d'une haute fréquence prédéterminée $f_2$ supérieure à $f_1$ ;
   - des moyens (21) de compensation amplifiant et intégrant une partie du signal composée des parties de son spectre de fréquence comprise entre les fréquences $f_1$ et $f_2$, ces moyens de compensation ayant un gain qui est une fonction décroissante de la fréquence dans la bande de fréquence entre $f_1$ et $f_2$ et constante en fonction de la fréquence au dessus de $f_2$,

8

- un canal optique (30) capable de recevoir des signaux électriques, de les transformer en signaux optiques, de les transmettre à distance sous cette forme, et de les restituer sous forme électrique, caractérisé en ce que le canal optique (30) reçoit les signaux électriques en provenance des moyens d'intégration (20), les moyens (21) de compensation étant situés fonctionnellement en aval du canal optique (30).

2.  Dispositif selon la revendication 1, caractérisé en ce qu'il comporte en aval des moyens d'intégration (20) et en amont du canal optique (30) un circuit d'amplification (23).

3.  Dispositif selon la revendication 2, caractérisé en ce que le circuit d'amplification (23) à un gain A1, permettant d'amener le niveau de bruit $B_1$ au niveau de la sortie des moyens (20) d'intégration, au niveau de bruit $B_2$ du canal optique.

4.  Dispositif selon la revendication 2, caractérisé en ce que le canal optique (30) comporte un circuit émetteur (31) émettant un signal optique à partir d'un signal électrique, une fibre optique (32) recevant le signal en sortie de l'émetteur (31) un circuit récepteur (33) convertissant le signal de la fibre en signal électrique.

5.  Dispositif selon la revendication 4, caractérisé en ce que l'émetteur optique (31) comporte une diode (28) électroluminescente.

6.  Dispositif selon la revendication 4, caractérisé en ce que l'émetteur comporte une diode laser (28).

7.  Dispositif selon la revendication 4, caractérisé en ce que le récepteur optique (33) comporte une photodiode (38) PIN.

8.  Dispositif selon la revendication 4, caractérisé en ce que le récepteur optique (33) comporte une photodiode (38) avalanche.

9.  Dispositif selon la revendication 2, caractérisé en ce que le gain des moyens de compensation (21) entre les fréquences $f_1$ et $f_2$ a une pente de -6 dB par octave.

10. Dispositif selon la revendication 2, caractérisé en ce que les moyens de compensation (21) comportent au moins un amplificateur large bande (51).

11. Dispositif selon la revendication 2, caractérisé en ce que les moyens de compensation (21) comportent au moins un transistor (60).

12. Dispositif selon l'une des revendications 1 à 9, caractérisé en ce que le dispositif comporte en aval du canal optique (30) des moyens de conversion analogique numérique (71) et en ce que les moyens de compensation (21) sont constitués par un calculateur numérique (70) dans lequel est incorporé un module de calcul réalisant la compensation.

CAPTEUR 10

11 Rc

Rc 12

R2 20 21
C2 22

CANAL OPTIQUE 30

**FIG. 1**

Gain

$G\dfrac{f2}{f1}$

$G$

f1    f2    Log f

**FIG. 2**

FIG.3

FIG.4

FIG.5

FIG.6

FIG. 7

FIG.8

$$(Ts) = K \frac{s + 2\pi f2}{s + 2\pi f1}$$

CAN

EP 0 598 647 A1

Office européen
des brevets

**RAPPORT DE RECHERCHE EUROPEENNE**

Numero de la demande

EP 93 40 2748

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | EP-A-0 501 169 (ASEA BROWN BOVERI) <br> * page 6, ligne 26 - ligne 36; figures 2,3 * <br> * page 3, ligne 27 - ligne 37 * <br> * page 6, ligne 21 - ligne 25 * | 1 | G01R29/08 <br> G01R15/07 |
| A | | 3 | |
| Y | EP-A-0 477 087 (THOMSON-CSF) <br> * abrégé; revendication 1; figure 2 * <br> * colonne 2, ligne 3 - ligne 22 * | 1 | |
| A | | 3 | |
| D | & FR-A-2 667 158 (THOMSON-CSF) <br> --- | | |
| A | ONDE ELECTRIQUE, <br> vol.70, no.2, 1990, PARIS FR <br> pages 21 - 26 <br> H.GIRAUD ET AL. 'Utilisation d'une cellule TEM pour essais en compatibilité électromagnétique (IEM,CEM)' <br> * résumé * <br> * figures 9,10 * | 1 | |
| | | | **DOMAINES TECHNIQUES RECHERCHES (Int.Cl.5)** |
| A | IEEE TRANSACTIONS ON INDUSTRIAL ELECTRONICS, <br> vol.35, no.3, Août 1988, NEW YORK US <br> pages 426 - 433 <br> E.M.THOMSON ET AL. 'A Remote Sensor for the Three Components of Transient Electric Fields' <br> * abrégé; figures 2,3 * | 1 | G01R |
| A | EP-A-0 068 394 (SIEMENS) <br> * page 14, ligne 5 - page 15, ligne 3; figure 2 * <br> ----- | 3 | |

Le présent rapport a été établi pour toutes les revendications

| Lieu de la recherche | Date d'achèvement de la recherche | Examinateur |
|---|---|---|
| BERLIN | 2 Février 1994 | Fritz, S |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P04C02)

14